# EUROPEAN PATENT APPLICATION

(11) **EP 4 333 600 A2**
(43) Date of publication of application: **06.03.2024**
(21) Application number: 23193079.3
(22) Date of filing: 24.08.2023
(51) Int. Cl.: H10K 59/80

(54) **DISPLAY DEVICE**

(30) Priority: 30.08.2022 KR 20220109410
(71) Applicant: Samsung Display Co., Ltd., Yongin-si, Gyeonggi-do 17113 (KR)
(72) Inventor: KIM, SEUNGHAN, 17113 Giheung-Gu, Yongin-si (KR); SONG, HYUN-GUE, 17113 Giheung-Gu, Yongin-si (KR); HONG, SANG MIN, 17113 Giheung-Gu, Yongin-si (KR); Jeong, Heeseong, 17113 Giheung-gu, Yongin-si (KR)
(74) Representative: Dr. Weitzel & Partner

(57) **Abstract**

A display device includes: a base layer (BL); a pixel defining film (PDL) on the base layer; a light emitting element (ED-R, ED-G, ED-B) including a light emitting layer in an opening (OP) in the pixel defining film; a capping layer (CPL) on the light emitting element; and an encapsulation layer (TFE) on the capping layer. The encapsulation layer includes: a first optical layer (OL1) on the capping layer; a second optical layer (OL2) on the first optical layer; and a stabilization layer (STL) on the second optical layer. A thickness of the stabilization layer is greater than a thickness of the first optical layer and a thickness of the second optical layer. A refractive index of the capping layer is higher than a refractive index of the first optical layer, and a refractive index of the second optical layer is higher than the refractive index of the first optical layer and a refractive index of the stabilization layer.

## Description

### BACKGROUND

Aspects of embodiments of the present disclosure relate to a display device.

Display devices, such as a smart phone, a tablet PC, a laptop computer, a navigation system, and a smart TV, are being developed. The display devices must satisfy display quality requirements for respective purposes of use. Light generated from a light emitting element in the display device is emitted to the outside of the display device while causing various optical phenomena, such as resonance and interference. Such optical phenomena may affect the quality of a displayed image.

### SUMMARY

Embodiments of the present disclosure provide a display device with improved display quality.

The invention is defined by the independent claims. According to the invention, a display device includes a base layer, a pixel defining film on the base layer and having an opening, a light emitting element including a light emitting layer within the opening, a capping layer on the light emitting element, and an encapsulation layer on the capping layer. The encapsulation layer includes a first optical layer on the capping layer, a second optical layer on the first optical layer, and a stabilization layer on the second optical layer. A thickness of the stabilization layer is greater than a thickness of the first optical layer and a thickness of the second optical layer. A refractive index of the capping layer is higher than a refractive index of the first optical layer, and a refractive index of the second optical layer is higher than the refractive index of the first optical layer and a refractive index of the stabilization layer.

A thickness of the first optical layer and a thickness of the second optical layer may be equal. The first optical layer may be in contact with the entire surface of the capping layer. The thickness of the stabilization layer may be between five and eight times bigger than the thickness of the first optical layer and/or the thickness of the second optical layer. The encapsulation layer may cover the opening and the pixel defining film, in particular as a continuous layer.

The thickness of each of the first optical layer and the second optical layer may be equal to or greater than about 50 nm (500 Å) and equal to or smaller than about 250 nm (2500 Å), and the thickness of the stabilization layer may be equal to or greater than about 400 nm (4000 Å) and equal to or smaller than about 900 nm (9000 Å).

A thickness of the capping layer may be smaller than the thickness of the first optical layer and the thickness of the second optical layer.

The encapsulation layer may further include an optical control layer on the stabilization layer and having a refractive index lower than the refractive index of the stabilization layer.

A thickness of the optical control layer may be smaller than the thickness of the first optical layer and the thickness of the second optical layer.

The refractive index of the capping layer may be equal to or higher than about 1.6 and equal to or lower than about 2.3.

The refractive index of the first optical layer may be equal to or higher than about 1.48 and equal to or lower than about 1.77.

The refractive index of the second optical layer may be equal to or higher than about 1.62 and equal to or lower than about 1.89.

The refractive index of the stabilization layer may be equal to or higher than about 1.52 and equal to or lower than about 1.77.

The light emitting element may include a plurality of light emitting elements, and the plurality of light emitting elements may include a first light emitting element configured to emit light of a first color, a second light emitting element configured to emit light of a second color, and a third light emitting element configured to emit light of a third color.

The display device may further include a metal layer beneath the second light emitting element, and the light of the second color may be green light.

The display device may further include a reflection adjustment layer on the encapsulation layer. The reflection adjustment layer may include a pattern layer and a high refractive layer, and the pattern layer may have a refractive index lower than a refractive of the high refractive layer.

The pattern layer may overlap the pixel defining film.

The pattern layer may be adjacent to at least one of the first light emitting element and the third light emitting element.

The display device may further include a first encapsulation layer, a second encapsulation layer on the first encapsulation layer, and a third encapsulation layer disposed on the second encapsulation layer, and the first encapsulation layer may be the encapsulation layer.

A refractive index of the second encapsulation layer may be lower than the refractive index of the stabilization layer, and a refractive index of the third encapsulation layer may be about 1.89.

According to the invention, a display device includes a base layer, a pixel defining film on the base layer and having an opening, a light emitting element including a light emitting layer within the opening, a capping layer on the light emitting element, and an encapsulation layer on the capping layer. The encapsulation layer includes a first optical layer on the capping layer, a second optical layer on the first optical layer, and a stabilization layer on the second optical layer. Each of the first optical layer, the second optical layer, and the stabilization layer is made of a material including at least two from among silicon atoms, nitrogen atoms, and oxygen atoms, and a ratio of the oxygen atoms of the second optical layer is lower than oxygen ratios of the first optical layer and the stabilization layer, and a nitrogen ratio of the second optical layer is higher than nitrogen ratios of the first optical layer and the stabilization layer.

A thickness of each of the first optical layer and the second optical layer may be equal to or greater than about 50 nm (500 Å) and equal to or smaller than about 250 nm (2500 Å), and a thickness of the stabilization layer may be equal to or greater than about 400 nm (4000 Å) and equal to or smaller than about 90 nm (9000 Å).

The encapsulation layer may further include an optical control layer on the stabilization layer and having a refractive index lower than a refractive index of the stabilization layer.

A ratio of the silicon atoms of the first optical layer may be equal to or higher than about 40 % and equal to or lower than about 52 %, a ratio of the nitrogen atoms of the first optical layer may be equal to or higher than about 10 % and equal to or lower than about 34 %, and a ratio of the oxygen atoms of the first optical layer may be equal to or higher than about 14 % and equal to or lower than about 50 %.

A ratio of the silicon atoms of the second optical layer may be equal to or higher than about 47 % and equal to or lower than about 58 %, a ratio of the nitrogen atoms of the second optical layer may be equal to or higher than about 21 % and equal to or lower than about 42 %, and a ratio of the oxygen atoms of the second optical layer may be equal to or higher than about 0 % and equal to or lower than about 32 %.

A ratio of the silicon atoms of the stabilization layer may be equal to or higher than about 42 % and equal to or lower than about 52 %, a ratio of the nitrogen atoms of the stabilization layer may be equal to or higher than about 15 % and equal to or lower than about 34 %, and a ratio of the oxygen atoms of the stabilization layer may be equal to or higher than about 17 % and equal to or lower than about 41 %.

The display device may further include a first encapsulation layer, a second encapsulation layer on the first encapsulation layer, and a third encapsulation layer on the second encapsulation layer, and the first encapsulation layer may be the encapsulation layer.

A refractive index of the second encapsulation layer may be lower than a refractive index of the stabilization layer, and a refractive index of the third encapsulation layer may be about 1.89.

### BRIEF DESCRIPTION OF THE FIGURES

The above and other aspects and features of the present disclosure will become apparent by describing, in detail, embodiments thereof with reference to the accompanying drawings.
FIG. 1 is a perspective view of a display device according to an embodiment.
FIG. 2 is an exploded perspective view of the display device shown in FIG. 1.
FIG. 3A is a plan view showing a display panel according to an embodiment of the present disclosure.
FIG. 3B is a cross-sectional view of a display panel according to an embodiment of the present disclosure.
FIG. 4 is an enlarged cross-sectional view of the area AA in FIG. 3B.
FIG. 5 is a table showing refractive indices based on ratios of silicon atoms, nitrogen atoms, and oxygen atoms.
FIG. 6 is a graph showing a light emitting spectrum based on a viewing angle according to an embodiment of the present disclosure.
FIG. 7A is an enlarged cross-sectional view of an encapsulation layer according to an embodiment of the present disclosure.
FIG. 7B is an enlarged cross-sectional view of first to third encapsulation layers according to an embodiment of the present disclosure.
FIG. 8A is a plan view showing a portion of a display panel according to an embodiment of the present disclosure.
FIG. 8B is a cross-sectional view of a display panel taken along the line I-I' in FIG. 8A.
FIG. 8C is a graph showing a light emitting spectrum based on a viewing angle according to an embodiment of the present disclosure.
FIG. 9A is a plan view showing a portion of a display panel according to an embodiment of the present disclosure.
FIG. 9B is a plan view showing a portion of a display panel according to an embodiment of the present disclosure.
FIG. 9C is a cross-sectional view of a display panel taken along the line II-II' in FIG. 9B.
FIG. 9D is a graph showing a light emitting spectrum based on a viewing angle according to an embodiment of the present disclosure.
FIG. 10A is a cross-sectional view of a display panel taken along the line II-II' in FIG. 9B according to another embodiment of the present disclosure.
FIG. 10B is a graph showing a light emitting spectrum based on a viewing angle according to an embodiment of the present disclosure.

### DETAILED DESCRIPTION

Embodiments of the present disclosure may be variously changed and may have various forms. Thus, while embodiments will be illustrated in the drawings and will be described in detail in the text, these embodiments are not intended to limit the present disclosure to a particular form of disclosure.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the present disclosure will be described with reference to the drawings.

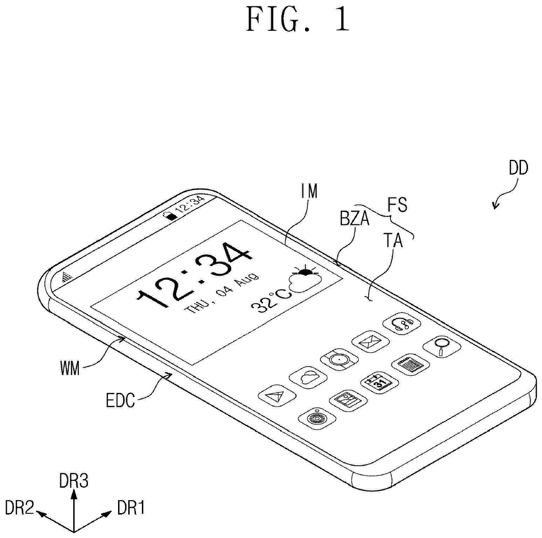

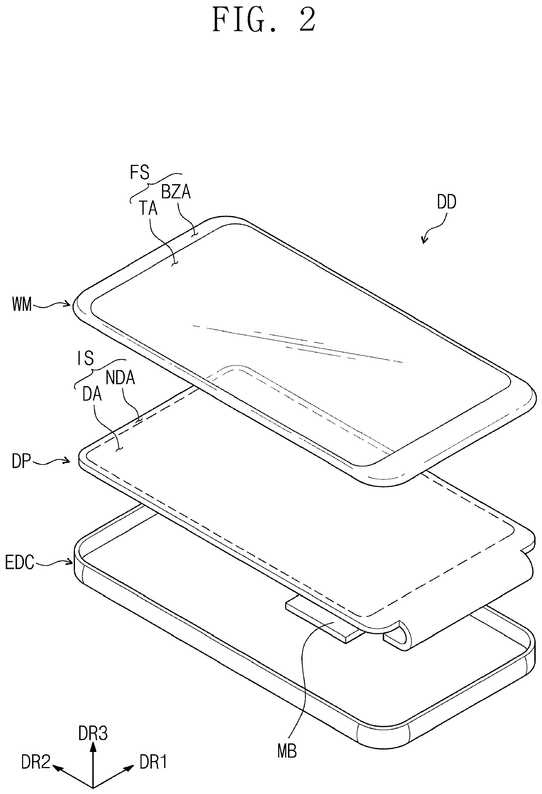

FIG. 1 is a perspective view of a display device according to an embodiment. FIG. 2 is an exploded perspective view of the display device shown in FIG. 1.

A display device DD may be a device that is activated in response to an electrical signal and displays an image. For example, the display device DD may be a large-sized device, such as a television or an external billboard, or a small/medium-sized device, such as a monitor, a mobile phone, a tablet PC, a computer, a navigation system, or a game console. Embodiments of the display device DD are illustrative and are not limited to one such device unless departing from the concept of the present disclosure. A mobile phone is shown as an example of the display device DD in the illustrated embodiment.

Referring to FIG. 1, the display device DD may have a rectangular shape having short sides extending in a first direction DR1 and long sides extending in a second direction DR2 crossing (or intersecting) the first direction DR1 on a plane. However, the present disclosure is not limited thereto, and the display device DD may have various shapes, such as a circle and a polygon on the plane.

The display device DD, in one embodiment, may be flexible. "Flexible," as used herein, refers to a property of being able to be bent and may include everything from a completely foldable structure to a structure that may be bent to a level of several nanometers. For example, the flexible display device DD may include a curved device or a foldable device. However, the present disclosure is not limited thereto, and the display device DD may be rigid.

The display device DD may display an image IM in a third direction DR3 on a display surface parallel to each of the first direction DR1 and the second direction DR2. The image IM provided (or emitted) by the display device DD may include a static image as well as a dynamic image. FIG. 1 shows a watch window and icons as an example of the image IM.

The display surface on which the image IM is displayed may correspond to a front surface of the display device DD, which may correspond to a front surface FS of a window WM. Although FIG. 1 illustratively shows a planar display surface, the display surface of the display device DD is not limited thereto and may include a curved surface bent from the plane at least at one edge thereof.

A front surface (or a top surface) and a rear surface (or a bottom surface) of each member constituting the display device DD may be opposite to each other in the third direction DR3, and a normal direction of each of the front surface and the rear surface may be substantially parallel to the third direction DR3. A separation distance between the front surface and the rear surface defined along the third direction DR3 may correspond to a thickness of the member (or a unit).

Referring to FIGS. 1 and 2, the display device DD may include the window WM, a display panel DP, and a casing EDC. The window WM may be coupled to the casing EDC to form an outer appearance of the display device DD and provide an internal space for accommodating the components of the display device DD.

The window WM may be disposed on the display panel DP. The window WM may have a shape corresponding to a shape of the display panel DP. The window WM may cover an entirety of an outer portion of the display panel DP and may protect the display panel DP from external impacts and scratches.

The window WM may include (or may contain) an optically transparent insulating material. For example, the window WM may include a glass substrate or a polymer substrate. The window WM may have a single-layer or multi-layer structure. The window WM may further include functional layers, such as an anti-fingerprint layer, a phase control layer, and a hard coating layer disposed on a transparent substrate.

The front surface FS of the window WM may have a transmissive area TA and a bezel area BZA. The transmissive area TA of the window WM may be an optically transparent area. The window WM may transmit the image IM provided by the display panel DP via the transmissive area TA, and a user may recognize the corresponding image IM.

The bezel area BZA of the window WM may be provided as an area on which a material with a color (e.g., a color material) is printed. The bezel area BZA of the window WM may prevent a component of the display panel DP disposed under but overlapping the bezel area BZA from being visually recognized from the outside.

The bezel area BZA may be adjacent to the transmissive area TA. A shape of the transmissive area TA may be substantially defined by the bezel area BZA. For example, the bezel area BZA may be disposed outwardly of the transmissive area TA and may surround the transmissive area TA. However, this is illustrated by way of example, and the bezel area BZA may be adjacent to only one side of the transmissive area TA or may be omitted. In addition, the bezel area BZA may be disposed on an inner surface of the display device DD instead of on the front surface.

The display panel DP may be disposed between the window WM and the casing EDC. The display panel DP may display the image IM in response to an electrical signal. The display panel DP, according to an embodiment, may be a light emitting display panel, but the present disclosure is not limited thereto. For example, the display panel DP may be an organic light emitting display panel, an inorganic light emitting display panel, or a quantum dot light emitting display panel. A light emitting layer of the organic light emitting display panel may include (or contain) an organic light emitting material, and a light emitting layer of the inorganic light emitting display panel may include (or contain) an inorganic light emitting material. A light emitting layer of the quantum dot light emitting display panel may include (or contain) a quantum dot, a quantum rod, or the like. Hereinafter, the display panel DP will be described as the organic light emitting display panel as an example.

The image IM provided by the display device DD may be displayed on a front surface IS of the display panel DP. The front surface IS of the display panel DP may have a display area DA and a non-display area NDA. The display area DA may be an area that is activated in response to the electrical signal and displays the image IM. According to one embodiment, the display area DA of the display panel DP may correspond to (e.g., may overlap) the transmissive area TA of the window WM.

Herein, an area or portion that "corresponds to" another area or portion means "overlapping each other" and is not limited to having the same area and/or the same shape.

The non-display area NDA may be adjacent to an outer portion of the display area DA. For example, the non-display area NDA may surround (e.g., may extend around a periphery of) the display area DA. However, the present disclosure is not limited thereto, and the non-display area NDA may have various shapes.

The non-display area NDA may be an area in which a driving circuit or a driving wiring for driving elements disposed in the display area DA, various signal lines for providing the electrical signals, pads, and the like are disposed. The non-display area NDA of the display panel DP may correspond to the bezel area BZA of the window WM. The components of the display panel DP disposed in the non-display area NDA may not be visually recognized (e.g., visible) from the outside because of the bezel area BZA.

The display device DD may include a circuit board MB connected to the display panel DP. The circuit board MB may be connected to one end of the display panel DP extending in the first direction DR1. The circuit board MB may generate the electrical signal provided to the display panel DP. For example, the circuit board MB may include a timing controller that generates a signal provided to a driver of the display panel DP in response to control signals received from the outside.

As an example of the present disclosure, at least a portion of the non-display area NDA of the display panel DP may be bent. The portion of the display panel DP to which the circuit board MB is connected may be bent such that the circuit board MB faces a rear surface of the display panel DP. The circuit board MB may be assembled by being disposed on a flat surface to overlap the rear surface of the display panel DP. However, the present disclosure is not limited thereto, and the display panel DP and the circuit board MB may be connected to each other via a flexible circuit board connected to respective ends of the display panel DP and the circuit board MB.

The casing EDC may be disposed beneath the display panel DP to accommodate the display panel DP therein. The casing EDC may include (or contain) a glass, plastic or metal material having a relatively high stiffness. The casing EDC may protect the display panel DP by absorbing the external impacts or preventing foreign substances/moisture from penetrating into the display panel DP.

In one example, the display device DD may further include an input sensing layer that is disposed on the display panel DP and is configured to sense an external input applied from the outside. The input sensing layer may be configured to sense various types of external inputs, such as force, pressure, temperature, light, and the like provided from the outside. For example, the input sensing layer may be configured to sense a touch by a user's body or a pen provided from the outside of the display device DD, or an input (e.g., hovering) applied close to the display device DD.

In addition, the display device DD may further include an electronic module including various functional modules for operating the display panel DP and a power supply module for supplying power required for the display device DD. For example, the display device DD may include a camera module as an example of the electronic module.

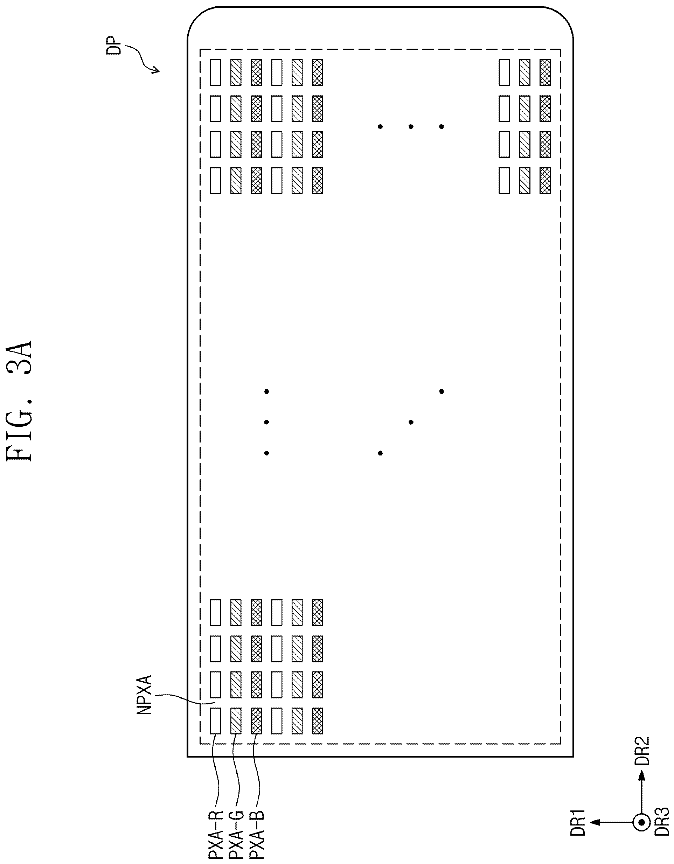

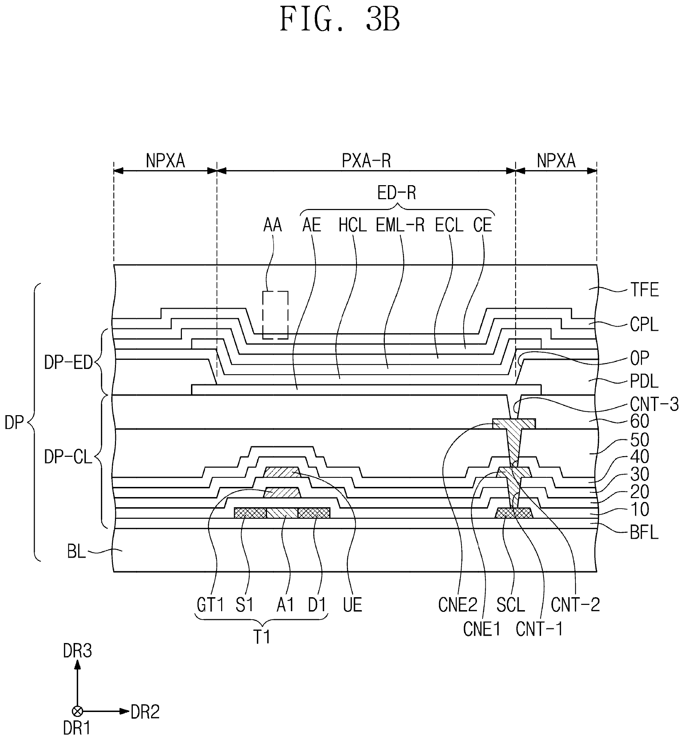

FIG. 3A is a plan view showing a display panel according to an embodiment of the present disclosure. FIG. 3B is a cross-sectional view of a display panel according to an embodiment of the present disclosure. The display panel DP shown in FIG. 3A may have a plurality of light emitting areas PXA-R, PXA-G, and PXA-B. The display panel DP may include the first light emitting area PXA-R, the second light emitting area PXA-G, and the third light emitting area PXA-B that are separated from each other. For example, the first light emitting area PXA-R may be a red light emitting area configured to emit red light, the second light emitting area PXA-G may be a green light emitting area configured to emit green light, and the third light emitting area PXA-B may be a blue light emitting area configured to emit blue light. The first to third light emitting areas PXA-R, PXA-G, and PXA-B may be separated from each other without overlapping each other when viewed on the plane defined by the first direction DR1 and the second direction DR2, and a non-light emitting area NPXA may be disposed between the adjacent light emitting areas PXA-R, PXA-G, and PXA-B.

In the display panel DP shown in FIG. 3A, the light emitting areas PXA-R, PXA-G, and PXA-B are arranged in a stripe shape. For example, in the display panel DP shown in FIG. 3A, each of the plurality of first light emitting areas PXA-R, the plurality of second light emitting areas PXA-G, and the plurality of third light emitting areas PXA-B may be aligned along the second direction DR2. In addition, the first light emitting area PXA-R, the second light emitting area PXA-G, and the third light emitting area PXA-B may be alternately arranged in the first direction DR1.

The arrangement of the light emitting areas PXA-R, PXA-G, and PXA-B is not limited to that shown in FIG. 3A, and an order in which the first light emitting area PXA-R, the second light emitting area PXA-G, and the third light emitting area PXA-B are arranged may vary depending on characteristics of a display quality of the display panel DP. For example, the arrangement of the light emitting areas PXA-R, PXA-G, and PXA-B may be a PENTILE^{®} (a registered trademark of Samsung Display Co., Ltd.) arrangement or a diamond arrangement. In addition, the arrangement of the light emitting areas PXA-R, PXA-G, and PXA-B may be variously adjusted or modified based on areas and shapes on the plane of the light emitting areas PXA-R, PXA-G, and PXA-B and the characteristics of the display quality of the display panel DP.

A common layer provided in common to overlap an entirety of the light emitting areas PXA-R, PXA-G, and PXA-B having such various arrangements and the non-light emitting area NPXA disposed between the light emitting areas PXA-R, PXA-G, and PXA-B may be manufactured (or formed) by using a mask.

Referring to FIG. 3B, the display panel DP may include a base layer BL, a circuit element layer DP-CL disposed on the base layer BL, a display element layer DP-ED, a capping layer CPL, and an encapsulation layer TFE disposed on the capping layer CPL.

The display element layer DP-ED may include first, second, and third light emitting elements. A stack structure of the display panel DP is not particularly limited.

The display panel DP may include a plurality of insulating layers, a semiconductor pattern, a conductive pattern, a signal line, and the like. The insulating layer, a semiconductor layer, and a conductive layer are formed via coating, vapor deposition, or the like. Thereafter, the insulating layer, the semiconductor layer, and the conductive layer may be selectively patterned via photolithography and etching. In this manner, the semiconductor pattern, the conductive pattern, the signal line, and the like included in the circuit element layer DP-CL and the display element layer DP-ED are formed.

The base layer BL may be a member that provides a reference surface on which components included in the circuit element layer DP-CL are disposed. The base layer BL may be a glass substrate, a metal substrate, a polymer substrate, or the like. However, the present disclosure is not limited thereto, and the base layer BL may be an inorganic layer, a functional layer, or a composite material layer.

The base layer BL may have a multi-layer structure. For example, the base layer BL may have a three-layer structure of a polymer resin layer, an adhesive layer, and a polymer resin layer. For example, the polymer resin layer may include (or contain) a polyimide-based resin. In addition, the polymer resin layer may (or contain) at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, and a perylene-based resin. Herein, a "∼∼-based" resin means a resin including (or containing) a "∼∼" functional group.

The circuit element layer DP-CL may be disposed on the base layer BL. Only some semiconductor patterns are shown in FIG. 3B, and at least one semiconductor pattern may be further disposed in the first light emitting area PXA-R. The semiconductor patterns may be arranged according to a specific rule or pattern. The semiconductor patterns have different electrical properties depending on whether they are doped or not. Each of the semiconductor patterns may have a first area having a high doping concentration and a second area having a low doping concentration. The first area may be doped with an N-type dopant or a P-type dopant. A P-type transistor includes the first area doped with the P-type dopant.

The first area has higher conductivity than the second area and acts as or substantially acts as an electrode or a signal line. The second area substantially corresponds to an active region (or a channel) of the transistor. For example, a portion of the semiconductor pattern may be the active region of the transistor, another portion thereof may be a source or a drain of the transistor, and still another portion thereof may be a conductive region.

As shown in FIG. 3B, a source S1, a channel A1, and a drain D1 of a transistor T1 are formed from the semiconductor pattern. FIG. 3B shows a portion of a signal transmitting region SCL formed from the semiconductor pattern. The signal transmitting region SCL may be connected to the drain D1 of the transistor T1 on a plane.

The circuit element layer DP-CL may include a buffer layer BFL, a first insulating layer 10, a second insulating layer 20, a third insulating layer 30, a fourth insulating layer 40, a fifth insulating layer 50, and a sixth insulating layer 60 disposed on the base layer BL. For example, the buffer layer BFL at the bottom, the first insulating layer 10, and the second insulating layer 20 may be inorganic layers, and the third insulating layer 30 may be an organic layer.

The buffer layer BFL improves a bonding force between the base layer BL and the semiconductor pattern and/or the conductive pattern. The buffer layer BFL may include at least one of a silicon oxide layer and a silicon nitride layer. The silicon oxide layer and the silicon nitride layer may be alternately stacked.

The first insulating layer 10 is disposed on the buffer layer BFL. The first insulating layer 10, the second insulating layer 20, the third insulating layer 30, the fourth insulating layer 40, the fifth insulating layer 50, and the sixth insulating layer 60 may be inorganic layers or organic layers. A gate GT1 of the first transistor T1 is on the first insulating layer 10. An upper electrode UE may be disposed on the second insulating layer 20. A first connecting electrode CNE1 may be disposed on the third insulating layer 30. The first connection electrode CNE1 may be connected to the signal transmitting region SCL through a contact hole (e.g., a contact opening) CNT-1 extending through the first to third insulating layers 10 to 30. A second connecting electrode CNE2 may be disposed on the fifth insulating layer 50. The second connecting electrode CNE2 may be connected to the first connecting electrode CNE1 through a contact hole (e.g., a contact opening) CNT-2 extending through the fourth insulating layer 40 and the fifth insulating layer 50. The sixth insulating layer 60 may be disposed on the fifth insulating layer 50. A first electrode AE is connected to the second connecting electrode CNE2 through a contact hole (e.g., a contact opening) CNT-3 extending through the sixth insulating layer 60.

At least one of the first connecting electrode CNE1 and the second connecting electrode CNE2 may be omitted. In other embodiments, an additional connecting electrode for connecting a first light emitting element ED-R and the transistor T1 may be further disposed. A scheme of the electrical connection between the first light emitting element ED-R and the transistor T1 may be variously changed based on the number of insulating layers disposed between the first light emitting element ED-R and the transistor T1 and is not limited to one embodiment.

The display element layer DP-ED may include a pixel defining film PDL and the first light emitting element ED-R disposed in an opening OP defined in the pixel defining film PDL.

The first light emitting element ED-R is disposed on the sixth insulating layer 60. The first light emitting element ED-R may include the first electrode AE, a hole control layer HCL, a first light emitting layer EML-R, an electron control layer ECL, and a second electrode CE. However, the present disclosure is not limited thereto. Different from the embodiment shown in FIG. 3B, in one embodiment, the hole control layer HCL, the electron control layer ECL, the second electrode CE, and the like may be patterned inside the opening OP defined in the pixel defining film PDL. In one embodiment, at least one of the hole control layer HCL, the first light emitting layer EML-R, the electronic control layer ECL, and the second electrode CE of the first light emitting element ED-R may be patterned by using an inkjet printing method. The first electrode AE may be electrically connected to the transistor T1 via the first connecting electrode CNE1 and the second connecting electrode CNE2.

The first electrode AE is disposed on the sixth insulating layer 60. The opening OP is defined in the pixel defining film PDL. The opening OP exposes at least a portion of the first electrode AE. The first light emitting area PXA-R may be defined to correspond to the first electrode AE exposed by the corresponding opening OP. The non-light emitting area NPXA may be adjacent to the first light emitting area PXA-R. The non-light emitting area NPXA may overlap the pixel defining film PDL.

The hole control layer HCL may be commonly disposed in the first light emitting area PXA-R and the non-light emitting area NPXA. The hole control layer HCL may include a hole transport layer and may further include a hole injection layer. The first light emitting layer EML-R is placed on the hole control layer HCL. The first light emitting layer EML-R may be disposed in an area corresponding to the opening OP.

The electron control layer ECL is disposed on the first light emitting layer EML-R. The electron control layer ECL may include an electron transport layer and may further include an electron injection layer. The second electrode CE is placed on the electron control layer ECL.

The capping layer CPL may be further disposed on the second electrode CE. The capping layer CPL may be composed of a plurality of layers or a single layer. In one embodiment, the capping layer CPL may be an organic layer or an inorganic layer. For example, when the capping layer CPL includes (or contains) an inorganic material, the capping layer CPL may include (or contain) an alkali metal compound, MgF₂, or the like. For example, when the capping layer CPL includes (or contains) an organic material, the organic material may include α-NPD, NPB, TPD, m-MTDATA, Alq₃, CuPc, TPD15(N4,N4,N4',N4'-tetra (biphenyl-4-yl) biphenyl-4,4'-diamine), TCTA(4,4',4"-Tris (carbazol-9-yl) triphenylamine), or the like, or may include an epoxy resin or an acrylate, such as methacrylate. However, the present disclosure is not limited thereto.

The encapsulation layer TFE is disposed on the capping layer CPL. The encapsulation layer TFE may include a plurality of thin films. The encapsulation layer TFE may cover the opening OP and the pixel defining film PDL, in particular as a continuous layer. Details will be described later.

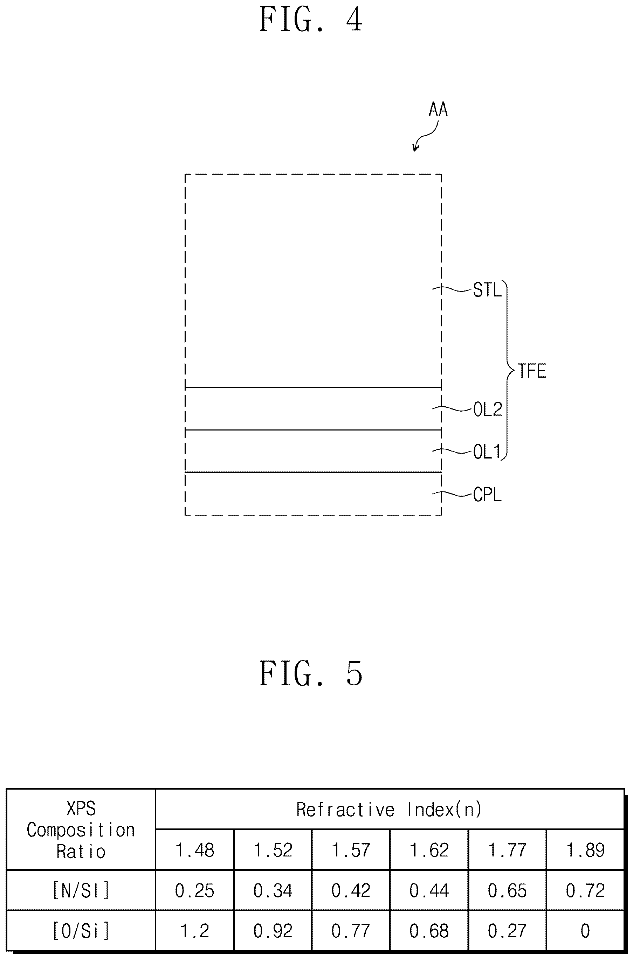

FIG. 4 is an enlarged cross-sectional view of the area AA in FIG. 3B according to an embodiment of the present disclosure. FIG. 5 is a table showing refractive indices based on ratios of silicon atoms, nitrogen atoms, and oxygen atoms.

Referring to FIG. 4, the encapsulation layer TFE is disposed on the capping layer CPL. The encapsulation layer TFE may include a first optical layer OL1, a second optical layer OL2, and a stabilization layer STL. A thickness of the first optical layer OP1 and a thickness of the second optical layer OP2 may be equal. The first optical layer OP1 may be in contact with the entire surface of the capping layer CPL. The capping layer CPL may be a continuous layer covering the opening OP and the pixel defining layer PDL, in particular with additional layers therebetween. The thickness of the stabilization layer STL may be between five and eight times bigger than the thickness of the first optical layer OP1 and/or the thickness of the second optical layer OP2.

A thickness of the capping layer CPL may be equal to or greater than about 40 nm (400 Å) and equal to or smaller than about 150 nm (1500 Å). In one embodiment, the thickness of the capping layer CPL may be about 640 Å. The thickness of the capping layer CPL may be smaller than each of a thickness of the first optical layer OL1 and a thickness of the second optical layer OL2. According to one embodiment of the present disclosure, a refractive index of the capping layer CPL may be equal to or higher than about 1.6 and equal to or lower than about 2.3. In one embodiment, the refractive index of the capping layer CPL may be about 2.0. The capping layer CPL, which is formed via a process separate from processes of the first optical layer OL1 and the second optical layer OL2, may not include (or contain) a silicon oxynitride (SiON).

The first optical layer OL1 may be disposed on the capping layer CPL. The thickness of the first optical layer OL1 may be equal to or greater than about 50 nm (500 Å) or and equal to or smaller than about 250 nm (2500 Å). The first optical layer OL1 may be a layer that increases a light emission efficiency by compensating for a resonance distance based on a wavelength of the light emitted from the first light emitting layer EML-R (see, e.g., FIG. 3B). Depending on the thickness of the first optical layer OL1, the light emitted from the first light emitting layer EML-R may form a secondary resonance. For the light emitted from the first light emitting layer EML-R to form the secondary resonance, the thickness of the first optical layer OL1 should be equal to or smaller than about 250 nm (2500 Å). In one embodiment, the thickness of the first optical layer OL1 may be about 140 nm (1400 Å). According to one embodiment of the present disclosure, a refractive index of the first optical layer OL1 may be equal to or higher than about 1.48 and equal to or lower than about 1.77. In one embodiment, the refractive index of the first optical layer OL1 may be about 1.57. As an example of the present disclosure, the refractive index of the capping layer CPL may be higher than that of the first optical layer OL1.

The first optical layer OL1 may be made of a material including (or containing) at least two silicon atoms (Si), nitrogen atoms (N), and oxygen atoms (O). Referring to FIG. 5, the refractive indices based on the ratios of the silicon atom (Si), the nitrogen atoms (N), and the oxygen atoms (O) are shown. The table shown in FIG. 5 shows values obtained by calculating refractive indices based on the ratio of the nitrogen atoms (N) and the ratio of the oxygen atoms (O) when the ratio of the silicon atom (Si) is converted to 1. For example, when the refractive index is about 1.48, a ratio of the nitrogen atoms (N) and the silicon atom (Si) is 1:4 (0.25:1), and a ratio of the oxygen atom (O) and the silicon atom (Si) is 6:5 (1.2:1). When expressing those as a composition ratio, in the case in which the refractive index is about 1.48, a composition ratio of about 40 % silicon atoms (Si), about 10 % nitrogen atoms (N), and about 50 % oxygen atoms (O) may be obtained.

According to one embodiment of the present disclosure, in the first optical layer OL1, the ratio of the silicon atoms may be equal to or higher than about 40 % and equal to or lower than about 52 %, the ratio of the nitrogen atoms may be equal to or higher than about 10 % and equal to or lower than about 34 %, and the ratio of the oxygen atoms may be equal to or higher than about 14 % and equal to or lower than about 50 %. When calculating the refractive index of the first optical layer OL1 based on such composition ratio, the range equal to or higher than about 1.48 and equal to or lower than about 1.77 may be derived. That is, as an example of the present disclosure, the refractive index of the first optical layer OL1 may be equal to or higher than about 1.48 and equal to or lower than about 1.77.

The second optical layer OL2 may be disposed on the first optical layer OL1. The thickness of the second optical layer OL2 may be equal to or greater than about 50 nm (500 Å) and equal to or smaller than about 250 nm (2500 Å). The second optical layer OL2 may be a layer that increases the light emission efficiency by compensating for the resonance distance based on the wavelength of the light emitted from the first light emitting layer EML-R. Depending on the thicknesses of the first optical layer OL1 and the second optical layer OL2, the light emitted from the first light emitting layer EML-R may form the secondary resonance. For the light emitted from the first light emitting layer EML-R to form the secondary resonance, the thickness of the second optical layer OL2 should be equal to or smaller than about 250 nm (2500 Å). In one embodiment, the thickness of the second optical layer OL2 may be about 125 nm (1250 Å). According to one embodiment of the present disclosure, a refractive index of the second optical layer OL2 may be equal to or higher than about 1.62 and equal to or lower than about 1.89. In one embodiment, the refractive index of the second optical layer OL2 may be about 1.89. As an example of the present disclosure, the refractive index of the second optical layer OL2 may be higher than the refractive index of the first optical layer OL1.

According to one embodiment of the present disclosure, the second optical layer OL2 may be made of the material including (or containing) at least two silicon atoms (Si), nitrogen atoms (N), and oxygen atoms (O). Referring to FIG. 5, in the second optical layer OL2, the ratio of the silicon atoms may be equal to or higher than about 47 % and equal to or lower than about 58 %, the ratio of the nitrogen atoms may be equal to or higher than about 21 % and equal to or lower than about 42 %, and the ratio of the oxygen atoms may be equal to or higher than about 0 % and equal to or lower than about 32 %. When calculating the refractive index of the second optical layer OL2 based on such composition ratio, the range equal to or higher than about 1.62 and equal to or lower than about 1.89 may be derived. That is, as an example of the present disclosure, the refractive index of the second optical layer OL2 may be equal to or higher than about 1.62 and equal to or lower than about 1.89.

The stabilization layer STL may be disposed on the second optical layer OL2. A thickness of the stabilization layer STL may be equal to or greater than about 400 nm (4000 Å) and equal to or smaller than about 900 nm (9000 Å). The stabilization layer STL acts as a protective layer to protect the first optical layer OL1 and the second optical layer OL2 from external moisture and foreign substances. As an example of the present disclosure, the thickness of the stabilization layer STL is equal to or greater than about 400 nm (4000 Å) to act as a protective layer. In one embodiment, the thickness of the stabilization layer STL may be about 900 nm (9000 Å). According to one embodiment of the present disclosure, a refractive index of the stabilization layer STL may be equal to or higher than about 1.52 and equal to or lower than about 1.89. In one embodiment, the refractive index of the stabilization layer STL may be about 1.62. As an example of the present disclosure, the refractive index of the second optical layer OL2 may be higher than the refractive index of the stabilization layer STL.

According to one embodiment of the present disclosure, the stabilization layer STL may be made of the material including (or containing) at least two silicon atoms (Si), nitrogen atoms (N), and oxygen atoms (O). Referring to FIG. 5, in the stabilization layer STL, the ratio of the silicon atoms may be equal to or higher than about 44 % and equal to or lower than about 52 %, the ratio of the nitrogen atoms may be equal to or higher than about 15 % and equal to or lower than about 34 %, and the ratio of the oxygen atoms may be equal to or higher than about 14 % and equal to or lower than about 41 %.

When calculating the refractive index of the stabilization layer STL based on such composition ratio, the range equal to or higher than about 1.52 and equal to or lower than about 1.77 may be derived. That is, as an example of the present disclosure, the refractive index of the stabilization layer STL may be equal to or higher than about 1.52 and equal to or lower than about 1.77.

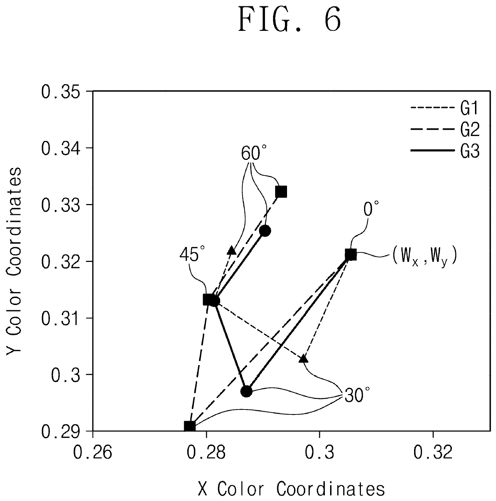

FIG. 6 is a graph showing a change in light emitting spectrum based on a viewing angle according to an embodiment of the present disclosure. A graph to be described below is shown in a portion of CIE 1931 color coordinates.

When viewing light emitted from the display device DD while changing the viewing angle, a phenomenon in which a white color changes to another color (hereinafter, referred to as a white shift phenomenon) may occur. A first comparison graph G1, a second comparison graph G2, and a third graph G3 represent spectra of the light emitted from the display device DD. Spectra of the light with viewing angles of 0 ° and 45 ° are set as reference values. That is, coordinate values of the CIE 1931 color coordinates are fixed at points with the viewing angles of 0 ° and 45 °, and according to the embodiment, coordinate values of the CIE 1931 color coordinates may be changed at points with viewing angles of 30 ° and 60 °. The spectrum of the light corresponding to the viewing angle of 0 ° is expressed with color coordinates of (Wₓ,W_{y}).

The first comparison graph G1 shows a spectrum of light emitted from the display device DD according to a first comparative example. The first comparison graph G1 shows the spectrum of the light emitted from the display device DD in a case in which the encapsulation layer includes one high refractive layer. According to the first comparison graph G1, a point with the viewing angle of 30 ° is located at a right lower end of the CIE 1931 color coordinates. In a section including the point at which the viewing angle is 30 °, a white image is perceived by the user in a reddish-white color. A point at which the viewing angle is 60 ° is located relatively close to points where the viewing angles are 0 ° and 45 °, so that the white shift phenomenon does not appear significantly.

The second comparison graph G2 shows a spectrum of light emitted from the display device DD according to a second comparative example. The second comparison graph G2 shows the spectrum of the light emitted from the display device DD in a case in which the encapsulation layer includes one optical layer. According to the second comparison graph G2, a point with the viewing angle of 30 ° is located at a left lower end of the CIE 1931 color coordinates. In a section including the point at which the viewing angle is 30 °, a white image is perceived by the user in a bluish-white color. A point at which the viewing angle is 45 ° is biased toward the left lower end from the point at which the viewing angle is 30 ° and a point at which the viewing angle is 60 ° is considerably biased toward a right upper end from the point at which the viewing angle is 45 °, so that there may be a strong shift from the viewing angle of 0 ° to the viewing angle of 60 °.

The third graph G3 shows a spectrum of light emitted from the display device DD according to one embodiment of the present disclosure. As shown in FIG. 4, the encapsulation layer TFE may include the first optical layer OL1, the second optical layer OL2, and the stabilization layer STL. According to the third graph G3, a point with the viewing angle of 30 ° is located between the point at which the viewing angle is 30 ° in the first comparison graph G1 and the point at which the viewing angle is 30 ° in the second comparison graph G2 in the CIE 1931 color coordinates. Therefore, in the display device DD according to one embodiment of the present disclosure, the white image does not appear reddish or bluish to the user at the point at which the viewing angle is 30 ° when compared with the first comparative example and the second comparative example. For example, the display device DD with an improved display quality may be provided to the user by preventing the white image from being seen in the reddish-white color or the bluish-white color at the viewing angle of 30 °.

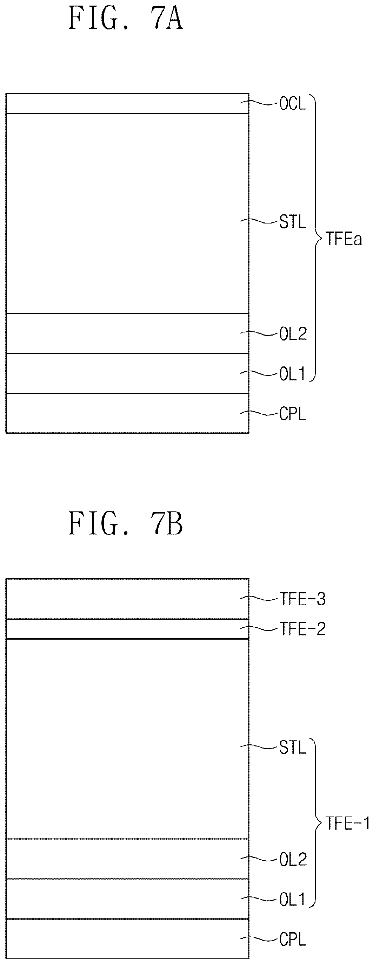

FIGS. 7A and 7B are enlarged cross-sectional views of the area AA in FIG. 3B according to other embodiments of the present disclosure.

Referring to FIG. 7A, an encapsulation layer TFEa according to an embodiment of the present disclosure may include the first optical layer OL1, the second optical layer OL2, the stabilization layer STL, and an optical control layer OCL. The optical control layer OCL may be disposed on the stabilization layer STL. According to one embodiment of the present disclosure, a refractive index of the optical control layer OCL is lower than the refractive index of the stabilization layer STL. In one embodiment, the refractive index of the optical control layer OCL may be about 1.70. The optical control layer OCL may be a layer that prevents the light output from the first light emitting layer EML-R (see, e.g., FIG. 3B) from reflecting and not being output to the outside caused by a difference between the refractive index of the stabilization layer STL and a refractive index of a film disposed on the optical control layer OCL. A thickness of the optical control layer OCL may be smaller than the thickness of the first optical layer OL1 and the thickness of the second optical layer OL2. In one embodiment, the thickness of the optical control layer OCL may be about 50 nm (500 Å). The optical control layer OCL may include at least one silicon oxide layer or silicon nitride layer. The optical control layer OCL may be a layer in which the silicon oxide layer and the silicon nitride layer are alternately stacked. A high-density oxygen layer may be disposed on the optical control layer OCL.

Referring to FIG. 7B, a first encapsulation layer TFE-1 may include the first optical layer OL1, the second optical layer OL2, and the stabilization layer STL. The encapsulation layer TFE shown in FIG. 4 may be the same as the first encapsulation layer TFE-1 shown in FIG. 7B. That is, the encapsulation layer TFE shown in FIG. 4 may have the same configuration as the first encapsulation layer TFE-1 shown in FIG. 7B. Accordingly, the capping layer CPL may be disposed beneath the first encapsulation layer TFE-1.

The second encapsulation layer TFE-2 may be disposed on the first encapsulation layer TFE-1. According to one embodiment of the present disclosure, the second encapsulation layer TFE-2 may be an organic layer including (or containing) an organic material. The second encapsulation layer TFE-2 may provide a flat surface on the first encapsulation layer TFE-1. A curve formed on a top surface of the first encapsulation layer TFE-1 or particles existing on the first encapsulation layer TFE-1 may be covered by the second encapsulation layer TFE-2 so that an influence of a surface state of the top surface of the first encapsulation layer TFE-1 on components formed on the second encapsulation layer TFE-2 may be prevented. The second encapsulation layer TFE-2 may include (or contain) an organic material and may be formed via a solution process, such as spin coating, slit coating, or an inkjet process. A refractive index of the second encapsulation layer TFE-2 may be lower than the refractive index of the stabilization layer STL. In one embodiment, the refractive index of the second encapsulation layer TFE-2 may be about 1.52.

A third encapsulation layer TFE-3 may be disposed on the second encapsulation layer TFE-2. The third encapsulation layer TFE-3 is disposed on the second encapsulation layer TFE-2 to cover the second encapsulation layer TFE-2. The third encapsulation layer TFE-3 may be stably formed on a relatively flat surface compared to being disposed on the first encapsulation layer TFE-1. The third encapsulation layer TFE-3 seals moisture or the like released from the second encapsulation layer TFE-2 so that it does not to flow to the outside. The third encapsulation layer TFE-3 may include (or contain) a silicon nitride, a silicon oxide, or a combination thereof. The third encapsulation layer TFE-3 may be formed via a vapor deposition process. A refractive index of the third encapsulation layer TFE-3 may be higher than the refractive index of the second encapsulation layer TFE-2. In one embodiment, the refractive index of the third encapsulation layer TFE-3 may be about 1.89.

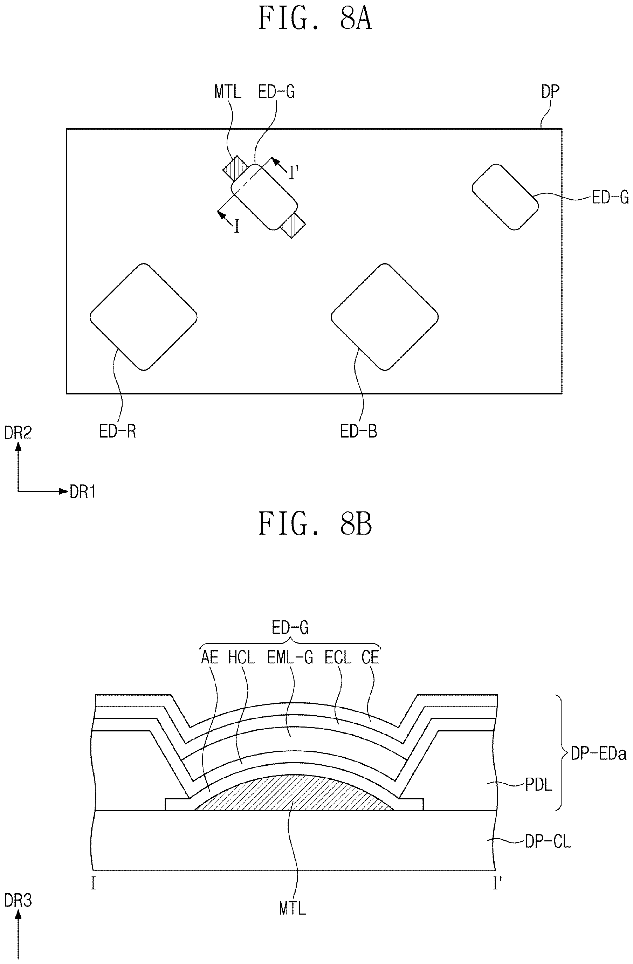

FIG. 8A is a plan view showing a portion of a display panel according to an embodiment of the present disclosure. FIG. 8B is a cross-sectional view taken along the link I-I' in FIG. 8A.

Referring to FIG. 8A, the display panel DP includes a plurality of light emitting elements ED-R, ED-G, and ED-B. The plurality of light emitting elements may include the first light emitting element ED-R (hereinafter, referred to as a red light emitting element) that is configured to output light of a first color, a second light emitting element ED-G (hereinafter, referred to as a green light emitting element) that is configured to output light of a second color, and a third light emitting element ED-B (hereinafter, referred to as a blue light emitting element) that is configured to output light of a third color. According to one embodiment of the present disclosure, the red light emitting element ED_R is configured to output the light of the first color (e.g., red light), the green light emitting element ED_G is configured to output the light of the second color (e.g., green light), and the blue light emitting element ED_B is configured to output the light of the third color (e.g., blue light).

Each of the red light emitting elements ED_R and each of the blue light emitting elements ED_B may be alternately arranged along the first direction DR1. The green light emitting elements ED_G may be arranged along the first direction DR1. Each of the green light emitting elements ED_G may be disposed between each of the red light emitting elements ED_R and each of the blue light emitting elements ED_B. As shown, the red light emitting element ED_R, the green light emitting element ED_G, and the blue light emitting element ED_B may have a rectangular shape with rounded corners. However, the present disclosure is not limited thereto, and the light emitting elements may have a polygonal shape (e.g., a rectangular shape or an octagonal shape).

Referring to FIGS. 8A and 8B, the display panel DP may further include a metal layer MTL disposed beneath the green light emitting element ED_G. For example, the metal layer MTL may be disposed between the circuit element layer DP-CL and the first electrode AE. The metal layer MTL may have a single-layer structure or a structure including a plurality of layers stacked along the third direction DR3. The metal layer MTL may contain molybdenum, silver, titanium, copper, aluminum, or an alloy thereof. According to one embodiment of the present disclosure, the metal layer MTL may overlap the green light emitting layer EML-G. In a cross-sectional view, the metal layer MTL may have an elliptical structure. As the metal layer MTL having the elliptical structure is formed, the green light emitting element ED_G may have a convex lens shape convex in the third direction DR3. However, the present disclosure is not limited thereto, and the green light emitting element ED_G may have a Fresnel lens shape. A convex lens is a lens having a convex shape because a central portion thereof is thicker than edges thereof. Because the convex lens has a light collecting property, the green light output from the green light emitting layer EML-G may be collected in a direction parallel to the third direction DR3. Accordingly, a light output efficiency of the green light emitting element ED_G may be increased.

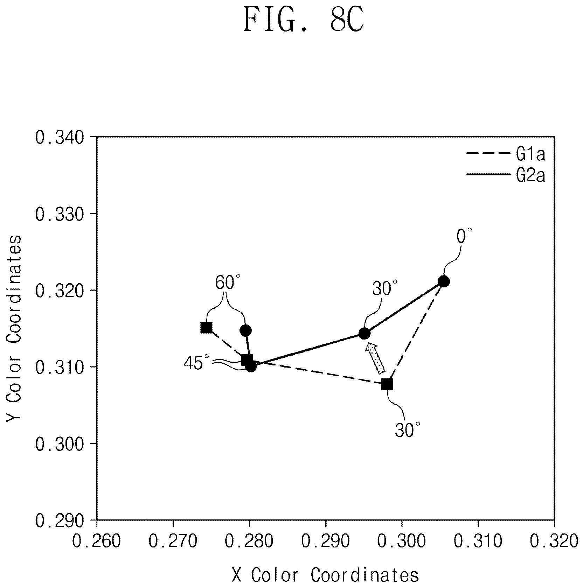

FIG. 8C is a graph showing a change in light emitting spectrum based on a viewing angle according to an embodiment of the present disclosure. Hereinafter, matters overlapping with those described above will be omitted.

A fourth comparison graph G1a shows a spectrum of light emitted from the display device DD according to a fourth comparative example. The fourth comparison graph G1a is a graph showing a spectrum of light emitted from the display device DD in which the metal layer MTL is not disposed only beneath the green light emitting element ED_G as in FIG. 8B but in which the metal layer MTL is also disposed beneath the red light emitting element ED_R and the blue light emitting element ED_B. According to the fourth comparison graph G1a, a point with the viewing angle of 30 ° is located at the right lower end in the CIE 1931 color coordinates. In a section including the point at which the viewing angle is 30 °, the white image is perceived by the user in the reddish-white color. A point at which the viewing angle is 60 ° is located at a left upper end but is located relatively close to points where the viewing angles are 0 ° and 45 ° so that the white shift phenomenon does not appear significantly.

A fifth graph G2a shows a spectrum of light emitted from the display device DD according to one embodiment of the present disclosure. Because the metal layer MTL is formed beneath the green light emitting element ED_G as shown in FIG. 8B, the green light emitting element ED_G may have the shape of the convex lens convex in the third direction DR3. According to the fifth graph G2a, a point at which the viewing angle is 30 ° is located at the left upper end, that is, between a point at which the viewing angle is 0 ° in the fifth graph G2a and a point at which the viewing angle is 45 ° in the fifth graph G2a when compared with the point at which the viewing angle is 30 ° of the first comparison graph G1 in the CIE 1931 color coordinates. Therefore, in the display device DD according to one embodiment of the present disclosure, when compared with the fourth comparative example, the white image does not appear reddish or bluish to the user at the point at which the viewing angle is 30 °. That is, the white image may be prevented being seen in the reddish-white color or the bluish-white color at the point at which the viewing angle is 30 °. In addition, when the viewing angle is changed from 0 ° to 45 °, the graph is formed almost in a straight line in the color coordinate system, so that the user may hardly notice the change in the light emitting spectrum, and thus, the display device DD may have improved display quality.

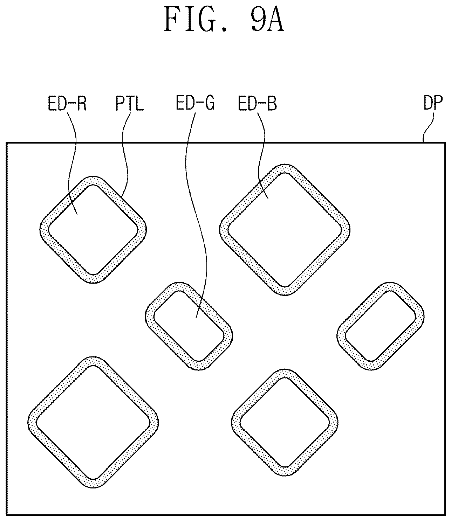

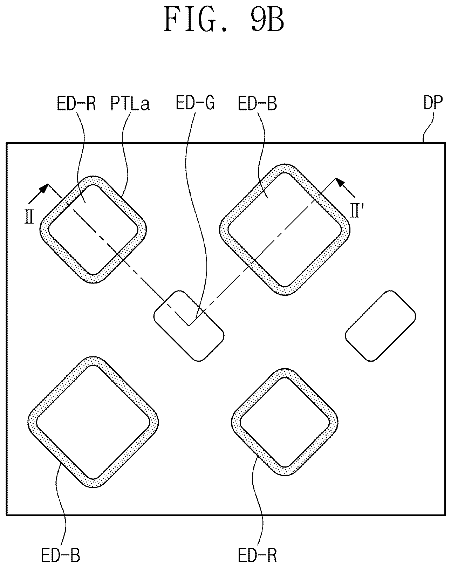

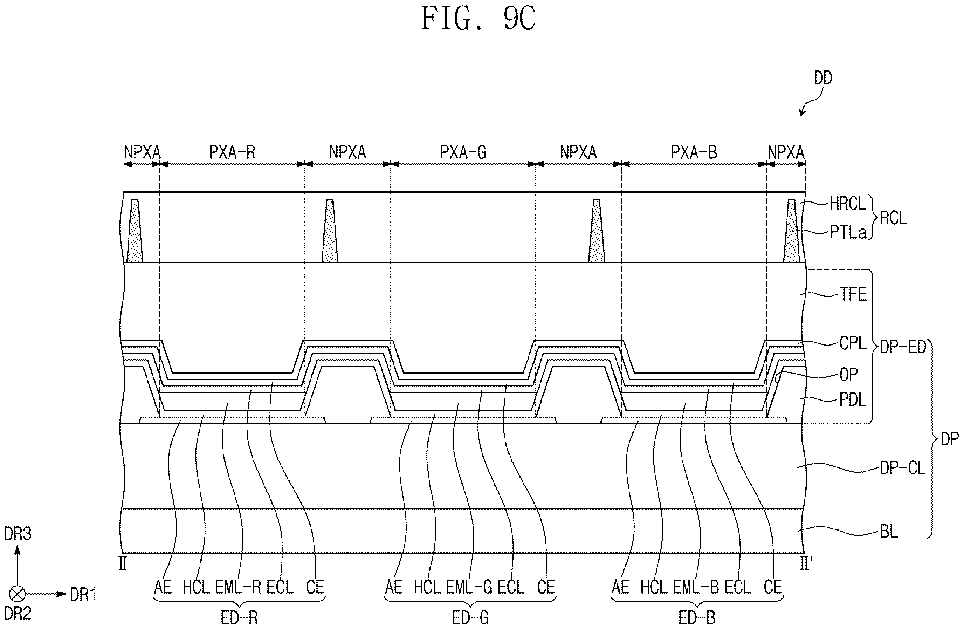

FIG. 9A is a plan view showing a portion of a display panel according to an embodiment of the present disclosure. FIG. 9B is a plan view showing a portion of a display panel according to an embodiment of the present disclosure. FIG. 9C is a cross-sectional view taken along the line II-II' in FIG. 9B.

Referring to FIG. 9A, the display panel DP includes the plurality of light emitting elements ED-R, ED-G, and ED-B. The plurality of light emitting elements may include the red light emitting element ED-R that is configured to output the red light, the green light emitting element ED-G that is configured to output the green light, and the blue light emitting element ED-B that is configured to output the blue light. The display panel DP may include a pattern layer PTL surrounding (e.g., extending around a periphery of) each of the red light emitting element ED-R, the green light emitting element ED-G, and the blue light emitting element ED-B.

Referring to FIG. 9B, a pattern layer PTLa may be disposed to be adjacent to at least one of the red light emitting element ED-R, the green light emitting element ED-G, and the blue light emitting element ED-B. As an example of the present disclosure, the pattern layer PTLa may be disposed to be adjacent to two light emitting elements, that is, the red light emitting element ED-R and the blue light emitting element ED-B. For example, the pattern layer PTLa may not be disposed to be adjacent to the green light emitting element ED-G. In other embodiments, the pattern layer PTLa may be disposed to be adjacent only to one of the red light emitting element ED-R, the green light emitting element ED-G, and the blue light emitting element ED-B (e.g., only to the blue light emitting element ED-B).

Referring to FIG. 9C, a reflection adjustment layer RCL may be disposed on the encapsulation layer TFE. The reflection adjustment layer RCL may include the pattern layer PTLa and a high refractive layer HRCL. The high refractive layer HRCL may be disposed to cover the pattern layer PTLa.

The pattern layer PTL may be disposed on the encapsulation layer TFE. Referring to FIGS. 9B and 9C, the pattern layer PTLa may not overlap the plurality of light emitting elements ED-R, ED-G, and ED-B. For example, the pattern layer PTLa may be disposed so as not to overlap (e.g., to be offset from) the light emitting areas PXA-R, PXA-G, and PXA-B but may overlap the non-light emitting area NPXA. Therefore, the pattern layer PTLa may overlap the pixel defining film PDL. According to one embodiment of the present disclosure, the pattern layer PTLa may be disposed adjacent only to the red light emitting element ED-R and the blue light emitting element ED-B. The pattern layer PTLa may have a ring shape surrounding (or extending around a periphery of) the red light emitting element ED-R and the blue light emitting element ED-B on a plane of the red light emitting element ED-R and the blue light emitting element ED-B. The pattern layer PTLa may include (or contain) a material having a low refractive index. For example, the refractive index of the pattern layer PTLa may be equal to or higher than about 1.45 and equal to or lower than about 1.65. By adjusting the refractive index of the pattern layer PTLa to be in the above range, a path of light traveling in a lateral direction of the light generated from the red light emitting element ED-R and the blue light emitting element ED-B may be changed to be in a forward direction.

The high refractive layer HRCL may include (or contain) a material having a high refractive index. For example, the refractive index of the pattern layer PTLa may be equal to or higher than about 2.0 and equal to or lower than about 2.3. According to one embodiment of the present disclosure, the high refractive layer HRCL may include (or contain) a polymer material. The high refractive layer HRCL may include (or contain) a high refractive monomer. For example, the high refractive layer HRCL may include (or contain) the acrylic resin. The high refractive layer HRCL may further include (or contain) nanoparticles.

The pattern layer PTLa and the high refractive layer HRCL may have different refractive indices. According to one embodiment of the present disclosure, the refractive index of the pattern layer PTLa is lower than the refractive index of the high refractive layer HRCL. For example, the pattern layer PTLa may have a refractive index that is lower than the refractive index of the high refractive layer HRCL by about 0.1 or more to change the path of the light traveling in the lateral direction of the light generated from the light emitting elements to be in the forward direction, thereby improving a light extraction efficiency of the display panel DP.

The lateral light traveling in the lateral direction from among the light generated by the red light emitting element ED-R and the blue light emitting element ED-B may be totally reflected from a side surface of the pattern layer PTLa. Accordingly, the path of the light may be changed such that the lateral light traveling in the lateral direction travels in the forward direction. Accordingly, a light emission efficiency in the forward direction of each of the red light emitting element ED-R and the blue light emitting element ED-B may be improved so that a light efficiency of the display panel DP may be improved. In this regard, because the difference between the refractive index of the high refractive layer HRCL and the refractive index of the pattern layer PTLa is greater, the total reflection of the lateral light traveling in the lateral direction of the pattern layer PTLa may be performed well on the side surface of the pattern layer PTLa. Accordingly, a ratio of light traveling in the forward direction increases so that a degree of improvement in the light efficiency may also increase.

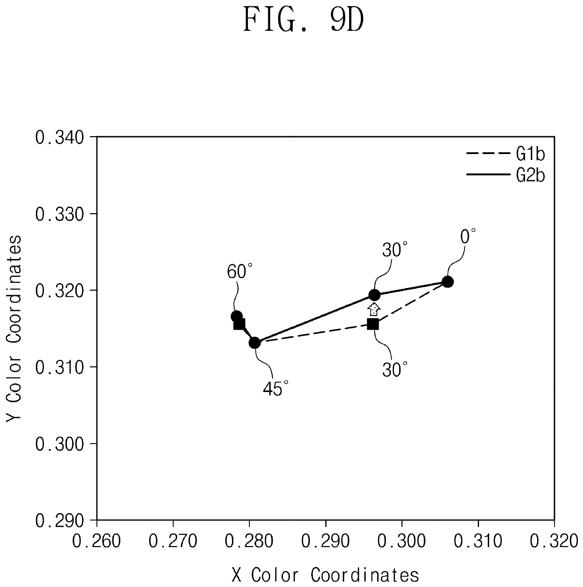

FIG. 9D is a graph showing a change in light emitting spectrum based on a viewing angle according to an embodiment of the present disclosure.

A sixth comparison graph G1b is a graph showing a spectrum of light emitted from the display device DD in which the pattern layer PTL is disposed to be adjacent to the red light emitting element ED-R, the green light emitting element ED-G, and the blue light emitting element ED-B as shown in FIG. 9A. A seventh graph G2b is a graph showing a spectrum of light emitted from the display device DD in which the pattern layer PTLa is disposed to be adjacent only to the red light emitting element ED-R and the blue light emitting element ED-B as shown in FIG. 9B as an embodiment of the present disclosure.

As shown in FIGS. 9B and 9C, because the pattern layer PTLa is disposed adjacent only to the red light emitting element ED-R and the blue light emitting element ED-B, a light efficiency may be improved only for the red light and the blue light. It may be seen that, in the CIE 1931 color coordinates, a point at which the viewing angle is 30 ° in the seventh graph G2b is located adjacent to a center of a line connecting a point with the viewing angle of 0 ° with a point with the viewing angle of 45 ° when compared to a point at which the viewing angle is 30 ° in the sixth comparison graph G1b. The display device DD according to an embodiment of the present disclosure may prevent the white image from being seen in the reddish-white color or the bluish-white color at the point at which the viewing angle is 30 ° when compared with the first comparative example. In addition, when the viewing angle is changed from 0 ° to 45 °, the graph is formed almost in a straight line in the color coordinate system, so that the user may hardly notice the change in the light emitting spectrum, and thus, the display device DD may exhibit improved display quality.

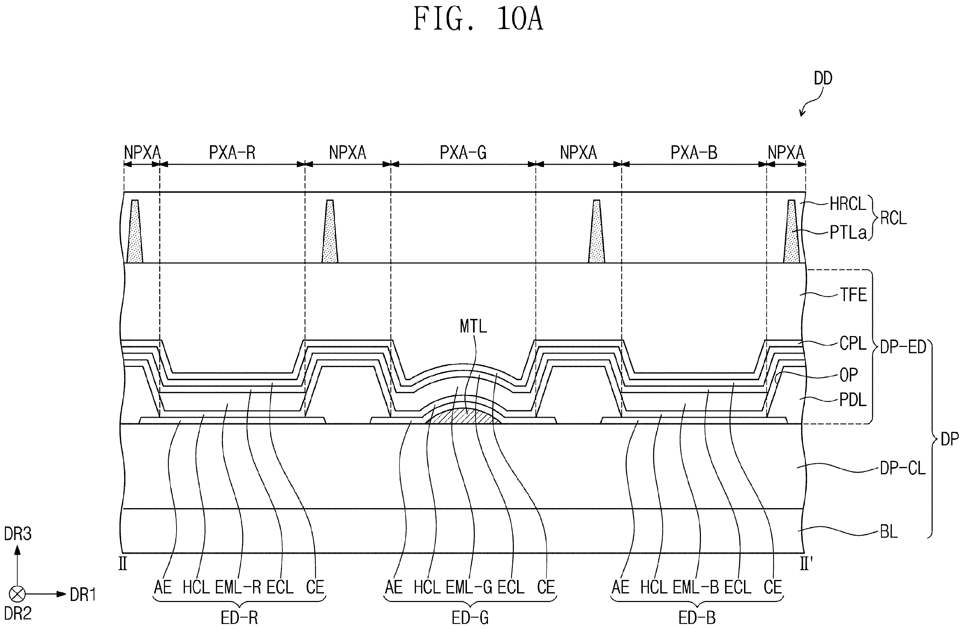

FIG. 10A is a cross-sectional view of a display panel according to an embodiment of the present disclosure.

Referring to FIG. 10A, the display panel DP may include a display element layer DP-EDa shown in FIG. 8B and the reflection adjustment layer RCL shown in FIG. 9C. According to one embodiment of the present disclosure, the display element layer DP-EDa may further include the metal layer MTL disposed beneath the green light emitting element ED_G. The metal layer MTL may be disposed between the circuit element layer DP-CL and the first electrode AE. According to one embodiment of the present disclosure, the metal layer MTL may overlap the green light emitting layer EML-G. In a cross-sectional view, the metal layer MTL may have the elliptical structure. When the metal layer MTL having the elliptical structure is formed, the green light emitting element ED_G may have the convex lens shape convex in the third direction DR3. However, the present disclosure is not limited thereto, and the green light emitting element ED_G may have the Fresnel lens shape. The convex lens is the lens having the convex shape because the central portion thereof is thicker than the edges thereof. Because the convex lens has the light collecting property, the green light output from the green light emitting layer EML-G may be collected in the direction parallel to the third direction DR3. Accordingly, the light output efficiency of the green light emitting element ED_G may be increased.

According to one embodiment of the present disclosure, the reflection adjustment layer RCL including the pattern layer PTL and the high refractive layer HRCL may be disposed on the encapsulation layer TFE. The pattern layer PTL may be disposed adjacent to the red light emitting element ED-R and the blue light emitting element ED-B on the plane. For example, the pattern layer PTL may not be disposed adjacent to only the green light emitting element ED-G. The refractive index of the pattern layer PTL may be lower than the refractive index of the high refractive layer HRCL so that the lateral light traveling in the lateral direction of the light generated by the red light emitting element ED-R and the blue light emitting element ED-B may be totally reflected from a side surface of the pattern layer PTL, and accordingly, the path of the light traveling in the lateral direction may be changed to be in the forward direction.

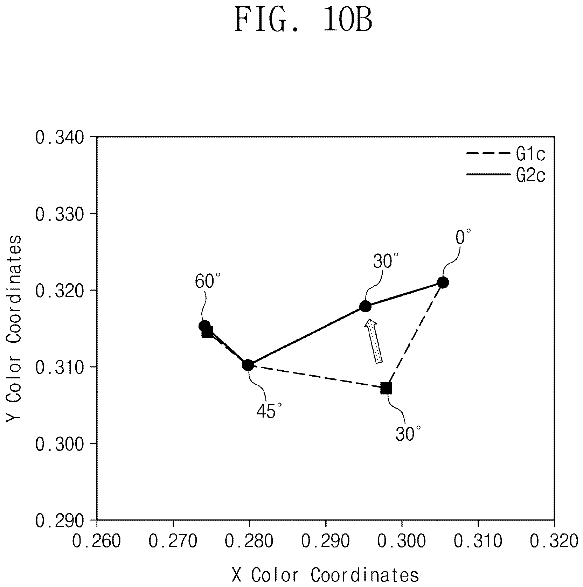

FIG. 10B is a graph showing a change in light emitting spectrum based on a viewing angle according to an embodiment of the present disclosure.

An eighth comparison graph G1c shows a spectrum of light emitted from the display device DD according to an eighth comparative example. The eighth comparison graph G1c is a graph showing the spectrum of the light emitted from the display device DD in which the metal layer MTL is disposed beneath the red light emitting element ED_R and the blue light emitting element ED_B and the pattern layer PTL is disposed adjacent to the red light emitting element ED-R, the green light emitting element ED-G, and the blue light emitting element ED-B. A ninth graph G2c is a graph showing a spectrum of light emitted from the display device DD in which the metal layer MTL is formed beneath the green light emitting element ED_G and the pattern layer PTL is disposed adjacent only to the red light emitting element ED-R and the blue light emitting element ED-B as an embodiment of the present disclosure.

According to the eighth comparison graph G1c, a point at which the viewing angle is 30 ° is located at the right lower end in the CIE 1931 color coordinates. The phenomenon in which the white image is seen in the reddish-white color has been ameliorated at the point at which the viewing angle is 30 ° in the eighth comparison graph G1c compared to the point at which the viewing angle is 30 ° in the first comparison graph G1 shown in FIG. 6, but in a section including the point at which the viewing angle is 30 ° in the eighth comparison graph G1c, the white image is still perceived by the user in the reddish-white color.

According to the ninth graph G2c, a point at which the viewing angle is 30 ° is located at the left upper end, that is, between a point at which the viewing angle is 0 ° and a point at which the viewing angle is 45 ° in the ninth graph G2c when compared with the point at which the viewing angle is 30 ° of the eighth comparison graph G1c. Therefore, in the display device DD according to one embodiment of the present disclosure, when compared with the eighth comparative example, the white image does not appear reddish or bluish to the user at the point at which the viewing angle is 30 °. That is, the white image may be prevented being seen in the reddish-white color or the bluish-white color at the point at which the viewing angle is 30 °. In addition, when the viewing angle is changed from 0 ° to 45 °, the graph is formed almost in a straight line in the color coordinate system, so that the user may hardly notice the change in the light emitting spectrum, and thus, the display device DD may exhibit improved display quality.

According to embodiments of the present disclosure, the encapsulation layer includes a plurality of optical layers having the different refractive indices so that, when light output from the light emitting element passes through the encapsulation layer, the plurality of optical layers with the different refractive indices form a resonator, thereby preventing a white image from being seen as a white-reddish color at a specific viewing angle of a user.

Accordingly, the technical scope of the present disclosure should not be limited to the content described in the detailed description of the specification but is defined by the claims and their equivalents.

## Claims

1. A display device (DD) comprising:
a base layer (BL);
a pixel defining film (PDL) on the base layer (BL) and having an opening (OP);
a light emitting element (ED-R, ED-G, ED-B) comprising a light emitting layer in the opening (OP) in the pixel defining film (PDL);
a capping layer (CPL) on the light emitting element (ED-R, ED-G, ED-B); and
an encapsulation layer (TFE) on the capping layer (CPL), the encapsulation layer (TFE) comprising:
a first optical layer (OL1) on the capping layer (CPL);
a second optical layer (OL2) on the first optical layer (OL1); and a stabilization layer (STL) on the second optical layer (OL2),
wherein a thickness of the stabilization layer (STL) is greater than a thickness of the first optical layer (OL1) and a thickness of the second optical layer (OL2), and
wherein a refractive index of the capping layer (CPL) is higher than a refractive index of the first optical layer (OL1), and a refractive index of the second optical layer (OL2) is higher than the refractive index of the first optical layer (OL1) and a refractive index of the stabilization layer (STL).

2. The display device (DD) of claim 1, wherein the thickness of each of the first optical layer (OL1) and the second optical layer (OL2) is equal to or greater than about 50 nm (500 Å) and equal to or smaller than about 250 nm (2500 Å), and
wherein the thickness of the stabilization layer (STL) is equal to or greater than about 400 nm (4000 Å) and equal to or smaller than about 900 nm (9000 Å).

3. The display device (DD) of claim 1 or 2, wherein a thickness of the capping layer (CPL) is smaller than the thickness of the first optical layer (OL1) and the thickness of the second optical layer (OL2).

4. The display device (DD) of at least one of claims 1 to 3, wherein the encapsulation layer (TFE) further comprises an optical control layer (OCL) on the stabilization layer (STL) and having a refractive index lower than the refractive index of the stabilization layer (STL).

5. The display device (DD) of claim 4, wherein a thickness of the optical control layer (OCL) is smaller than the thickness of the first optical layer (OL1) and the thickness of the second optical layer (OL2).

6. The display device (DD) of at least one of claims 1 to 5, wherein the refractive index of the capping layer (CPL) is equal to or higher than about 1.6 and equal to or lower than about 2.3.

7. The display device (DD) of at least one of claims 1 to 6, wherein the refractive index of the first optical layer (OL1) is equal to or higher than about 1.48 and equal to or lower than about 1.77.

8. The display device (DD) of at least one of claims 1 to 7, wherein the refractive index of the second optical layer (OL2) is equal to or higher than about 1.62 and equal to or lower than about 1.89.

9. The display device (DD) of at least one of claims 1 to 8, wherein the refractive index of the stabilization layer (STL) is equal to or higher than about 1.52 and equal to or lower than about 1.77.

10. The display device (DD) of at least one of claims 1 to 9, wherein the light emitting element (ED-R, ED-G, ED-B) comprises a plurality of light emitting elements,
wherein the plurality of light emitting elements comprises a first light emitting element (ED-R) configured to emit light of a first color, a second light emitting element (ED-G) configured to emit light of a second color, and a third light emitting element (ED-B) configured to emit light of a third color.

11. The display device (DD) of claim 10, further comprising a metal layer beneath the second light emitting element (ED-G),
wherein the light of the second color is green light.

12. The display device (DD) of at least one of claims 1 to 11, further comprising a reflection adjustment layer (RCL) on the encapsulation layer (TFE),
wherein the reflection adjustment layer (RCL) comprises a pattern layer (PTLa) and a high refractive layer (HRCL), and
wherein the pattern layer (PTLa) has a refractive index lower than a refractive of the high refractive layer (HRCL).

13. The display device (DD) of claim 12, wherein the pattern layer (PTLa) overlaps the pixel defining film (PDL).

14. The display device (DD) of claim 12 or 13, wherein the pattern layer (PTLa) is adjacent to at least one of the first light emitting element (ED-R) and the third light emitting element (ED-B).

15. The display device (DD) of at least one of claims 1 to 14, further comprising:
a first encapsulation layer (TFE-1);
a second encapsulation layer (TFE-2) on the first encapsulation layer (TFE-1); and
a third encapsulation layer (TFE-3) on the second encapsulation layer (TFE-2),
wherein the first encapsulation layer (TFE-1) is the encapsulation layer (TFE).

16. The display device of claim 15, wherein a refractive index of the second encapsulation layer (TFE-2) is lower than the refractive index of the stabilization layer (STL), and
wherein a refractive index of the third encapsulation layer (TFE-3) is about 1.89.

17. A display device (DD) comprising:
a base layer (BL);
a pixel defining film (PDL) on the base layer (BL) and having an opening (OP);
a light emitting element (ED-R, ED-G, ED-B) comprising a light emitting layer (EML-R, EML-G, EML-B) in the opening (OP);
a capping layer (CPL) on the light emitting element (ED-R, ED-G, ED-B); and
an encapsulation layer (TFE) on the capping layer (CPL), the encapsulation layer (TFE) comprising:
a first optical layer (OL1) on the capping layer (CPL);
a second optical layer (OL2) on the first optical layer (OL1); and
a stabilization layer (STL) on the second optical layer (OL2),
wherein each of the first optical layer (OL1), the second optical layer (OL2), and the stabilization layer (STL) is made of a material comprising at least two from among silicon atoms, nitrogen atoms, and oxygen atoms, and
wherein a ratio of the oxygen atoms of the second optical layer (OL2) is lower than oxygen ratios of the first optical layer (OL1) and the stabilization layer (STL), and a nitrogen ratio of the second optical layer (OL2) is higher than nitrogen ratios of the first optical layer (OL1) and the stabilization layer (STL).

18. The display device (DD) of claim 17, wherein a thickness of each of the first optical layer (OL1) and the second optical layer (OL2) is equal to or greater than about 50 nm (500 Å) and equal to or smaller than about 250 nm (2500 Å), and
wherein a thickness of the stabilization layer (STL) is equal to or greater than about 400 nm (4000 Å) and equal to or smaller than about 900 nm (9000 Å).

19. The display device (DD) of claim 17 or 18, wherein the encapsulation layer (TFE) further comprises an optical control layer (OCL) on the stabilization layer (STL) and having a refractive index lower than a refractive index of the stabilization layer (STL).

20. The display device (DD) of at least one of claims 17 to 19, wherein a ratio of the silicon atoms of the first optical layer (OL1) is equal to or higher than about 40 % and equal to or lower than about 52 %,
wherein a ratio of the nitrogen atoms of the first optical layer (OL1) is equal to or higher than about 10 % and equal to or lower than about 34 %, and
wherein a ratio of the oxygen atoms of the first optical layer (OL1) is equal to or higher than about 14 % and equal to or lower than about 50 %.

21. The display device (DD) of at least one of claims 17 to 20, wherein a ratio of the silicon atoms of the second optical layer (OL2) is equal to or higher than about 47 % and equal to or lower than about 58 %,
wherein a ratio of the nitrogen atoms of the second optical layer (OL2) is equal to or higher than about 21 % and equal to or lower than about 42 %, and
wherein a ratio of the oxygen atoms of the second optical layer (OL2) is equal to or higher than about 0 % and equal to or lower than about 32 %.

22. The display device (DD) of at least one of claims 17 to 21, wherein a ratio of the silicon atoms of the stabilization layer (STL) is equal to or higher than about 42 % and equal to or lower than about 52 %,
wherein a ratio of the nitrogen atoms of the stabilization layer (STL) is equal to or higher than about 15 % and equal to or lower than about 34 %, and
wherein a ratio of the oxygen atoms of the stabilization layer (STL) is equal to or higher than about 17 % and equal to or lower than about 41 %.

23. The display device (DD) of at least one of claims 17 to 22, further comprising:
a first encapsulation layer (TFE-1);
a second encapsulation layer (TFE-2) on the first encapsulation layer (TFE-1); and
a third encapsulation layer (TFE-3) on the second encapsulation layer (TFE-2),
wherein the first encapsulation layer (TFE-1) is the encapsulation layer (TFE).

24. The display device (DD) of claim 23, wherein a refractive index of the second encapsulation layer (TFE-2) is lower than a refractive index of the stabilization layer (STL), and
wherein a refractive index of the third encapsulation layer (TFE-3) is about 1.89.
